# EUROPEAN PATENT APPLICATION

(11) **EP 2 475 096 A1**
(43) Date of publication of application: **11.07.2012**
(21) Application number: 10811186.5
(22) Date of filing: 23.06.2010
(51) Int. Cl.: H03F 3/20

(54) **POWER AMPLIFIER AND RECEIVER IN USER DEVICE**

(30) Priority: 31.08.2009 CN 200920177821 U
(71) Applicant: Huawei Device Co., Ltd., Longgang District Shenzhen Guangdong 518129 (CN)
(72) Inventor: WANG, Hai, Shenzhen Guangdong 518129 (CN)
(74) Representative: Isarpatent
(86) International application number: PCT/CN2010/074298
(87) International publication number: WO 2011/023026

(57) **Abstract**

A Power Amplifier (PA) apparatus is provided. The PA apparatus includes: a first stage PA tube, configured to amplify gain of input signals; a first stage bias circuit connected to the first stage PA tube, configured to provide bias voltage for the first stage PA tube; a second stage PA tube connected to the first stage PA tube, configured to amplify gain of output signals of the first stage PA tube; a second stage bias circuit connected to the second stage PA tube, configured to provide bias voltage for the second stage PA tube; a reference voltage unit connected to the first stage bias circuit and the second stage bias circuit; and a voltage control unit connected to the first stage bias circuit and the second stage bias circuit, configured to connect and disconnect the first stage PA tube through the first stage bias circuit, and connect and disconnect the second stage PA tube through the second stage bias circuit. A receiving apparatus of a User Equipment (UE) is also provided. The receiving apparatus simplifies the structure of the PA apparatus, thereby reducing the production cost and improving the stability of the gain procedure.

## Description

### FIELD OF THE INVENTION

The present invention relates to the field of signal processing, and in particular, to a Power Amplifier (PA) apparatus, and a receiving apparatus of a User Equipment (UE).

### BACKGROUND OF THE INVENTION

In a receiving apparatus of a UE of a mobile communication system such as the Wideband Code Division Multiple Access (WCDMA) network, the Code Division Multiple Access (CDMA) network, and the Time Division Multiple Access (TDMA) network, a PA apparatus is a key apparatus. The PA apparatus needs to ensure that audio signals or video signals meet user requirements. Meanwhile, to reduce power consumption of the whole system, the PA apparatus needs to have the highest power amplification efficiency, namely, the highest efficiency of amplifying gain of signals. With the decrease of the output power of the PA apparatus, power amplification efficiency of the PA apparatus decreases monotonically.

In a PA apparatus of a receiving apparatus of a UE in the prior art, control signals are provided for the PA apparatus through signal voltage sets. Each signal voltage in a signal voltage set has two states. Two combined signal voltages provide three control modes in four control states. In the first control mode, high bias voltage is output to the PA tube to ensure that the PA tube works at the high power working point; in the second control mode, low bias voltage is output to the PA tube to ensure that the PA tube works at the low power working point; in the third control mode, a low power PA tube in the PA apparatus amplifies gain of the signal and outputs the signal.

In some specific environments, the design of the PA apparatus in the mobile terminal equipment in the WCDMA/CDMA/TDMA networks is excessively complicated, so that a low yield in producing the PA apparatus is caused. When the receiving apparatus of the UE is applied in the whole system, depending on different required output power, signals need to be transmitted by different circuits in the PA apparatus. The conversion between different circuits in the PA apparatus takes a certain time, and the conversion procedure of the different circuits affects stability of the gain of the PA apparatus and deteriorates the technical indices of the PA apparatus.

### SUMMARY OF THE INVENTION

The embodiments of the present invention provide a PA apparatus to solve the problems that the PA apparatus in the prior art has a complicated structure and bad stability.

The foregoing objectives are fulfilled through the following technical solutions adopted in the embodiments of the present invention:

A PA apparatus includes:
a first stage PA tube, configured to amplify gain of all input signals;
a first stage bias circuit connected to the first stage PA tube, configured to provide bias voltage for the first stage PA tube;
a second stage PA tube connected to the first stage PA tube, configured to amplify gain of output signals of the first stage PA tube;
a second stage bias circuit connected to the second stage PA tube, configured to provide bias voltage for the second stage PA tube;
a reference voltage unit connected to the first stage bias circuit and the second stage bias circuit, configured to provide voltage for the first stage bias circuit and the second stage bias circuit; and
a voltage control unit connected to the first stage bias circuit and the second stage bias circuit, configured to control connection and disconnection of the first stage PA tube through the first stage bias circuit, and control connection and disconnection of the second stage PA tube through the second stage bias circuit.

A receiving apparatus of a UE includes a PA apparatus, a signal receiving apparatus, and a signal sending apparatus.

The signal receiving apparatus is connected to the PA apparatus, and is configured to receive input signals and transfer the input signals to the PA apparatus.

The signal sending apparatus is connected to the PA apparatus, and is configured to send output signals of the PA apparatus.

The PA apparatus includes:
a first stage PA tube, configured to amplify gain of all input signals;
a first stage bias circuit connected to the first stage PA tube, configured to provide bias voltage for the first stage PA tube;
a second stage PA tube connected to the first stage PA tube, configured to amplify gain of output signals of the first stage PA tube;
a second stage bias circuit connected to the second stage PA tube, configured to provide bias voltage for the second stage PA tube;
a reference voltage unit connected to the first stage bias circuit and the second stage bias circuit, configured to provide voltage for the first stage bias circuit and the second stage bias circuit; and
a voltage control unit connected to the first stage bias circuit and the second stage bias circuit, configured to control connection and disconnection of the first stage PA tube through the first stage bias circuit, and control connection and disconnection of the second stage PA tube through the second stage bias circuit.

The receiving apparatus of the UE is applicable in mobile communication networks such as WCDMA, CDMA and TDMA.

After the embodiments of the present invention are adopted, by simplifying the structure of the PA apparatus, the production cost is reduced, and the yield and stability of the production are improved.

### BRIEF DESCRIPTION OF THE DRAWINGS

To make the technical solutions according to the embodiments of the present invention or in the prior art clearer, the following outlines the accompanying drawings involved in the description of the embodiments of the present invention or the prior art. Apparently, the accompanying drawings outlined below are illustrative rather than exhaustive, and persons of ordinary skill in the art can derive other drawings from them without any creative effort.

FIG. 1 is a probability distribution diagram of output power in the prior art;

FIG. 2 is a schematic structure diagram of embodiment 1 of a PA apparatus according to an embodiment of the present invention;

FIG. 3 is a schematic structure diagram of embodiment 2 of a PA apparatus according to an embodiment of the present invention; and

FIG. 4 is a schematic structure diagram of an embodiment of a receiving apparatus of a UE according to an embodiment of the present invention.

### DETAILED DESCRIPTION OF THE EMBODIMENTS

The following detailed description is given in conjunction with the accompanying drawings to provide a thorough understanding of the present invention. Evidently, the drawings and the detailed description are merely representative of particular embodiments of the present invention rather than all embodiments. All other embodiments, which can be derived by those skilled in the art from the embodiments given herein without any creative effort, shall fall within the scope of the present invention.

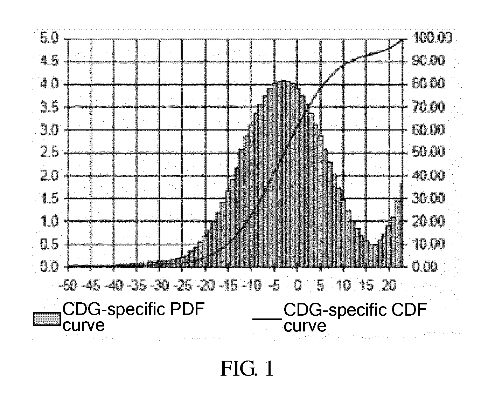

As observed by the CDMA Development Group (CDG), in a practical WCDMA network, the values of the output power of the receiving apparatus of the UE are distributed regularly when a voice call is under way. FIG. 1 is a probability distribution diagram of the output power in the prior art, and a Probability Density Function (PDF) curve of the power of the output signals, and a Cumulative Distribution Function (CDF) curve of the power of the output signals may be seen in FIG. 1.

Embodiment 1 of a PA Apparatus according to an embodiment of the present invention:

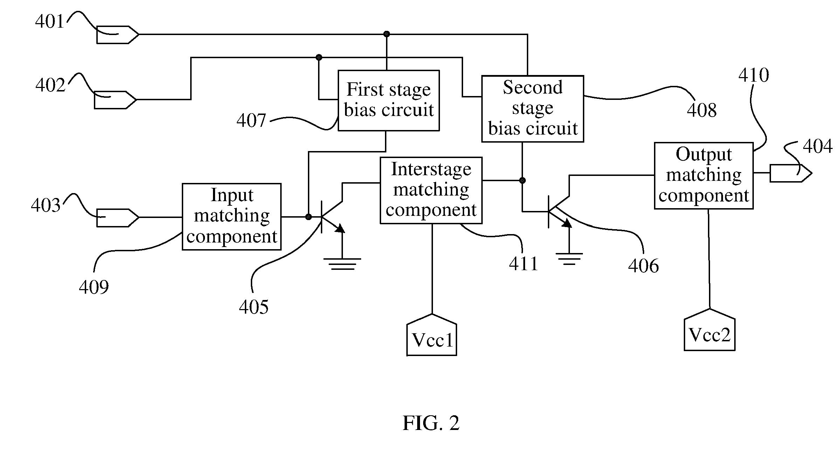

FIG. 2 is a schematic structure diagram of embodiment 1 of a PA apparatus according to an embodiment of the present invention. As shown in FIG. 2, the PA apparatus in this embodiment includes: a reference voltage unit 401, a voltage control unit 402, a first stage PA tube 405, a second stage PA tube 406, a first stage bias circuit 407, and a second stage bias circuit 408. The first stage PA tube 405 is configured to amplify gain of signals; the first stage bias circuit 407 is connected to the first stage PA tube 405, and is configured to provide bias voltage for the first stage PA tube 405; the second stage PA tube 406 is connected to the first stage PA tube 405, and is configured to amplify gain of the signals amplified by the first stage PA tube 405; the second stage bias circuit 408 is connected to the second stage PA tube 406, and is configured to provide bias voltage for the second stage PA tube 406; the reference voltage unit 401 is connected to the first stage bias circuit 407 and the second stage bias circuit 408, and is configured to provide voltage for the first stage bias circuit 407 and the second stage bias circuit 408; the voltage control unit 402 is connected to the first stage bias circuit 407 and the second stage bias circuit 408, and is configured to control connection and disconnection of the first stage PA tube 405 through the first stage bias circuit 407, and control connection and disconnection of the second stage PA tube 406 through the second stage bias circuit 408.

The PA apparatus in this embodiment further includes an input matching component 409 and an output matching component 410. The input matching component 409 is connected between a signal input end 403 and the first stage PA tube 405, and is configured to match a signal onto the first stage PA tube 405 to ensure that the signal power is input into the PA apparatus efficiently and the signal is amplified efficiently. The output matching component 410 is connected between the second stage PA tube 406 and a signal output end 404, and is configured to match the signal onto the signal output end 404 to ensure efficient outputting of the power signal amplified by the PA apparatus, reduce power loss, and amplify the signal efficiently.

The PA apparatus in this embodiment further includes an interstage matching component 411 which is connected between the first stage PA tube 405 and the second stage PA tube 406, and is configured to match the output signal amplified by the first stage PA tube 405 onto the second stage PA tube 406, reduce power loss caused by mismatch between the first stage PA tube 405 and the second stage PA tube 406, and obtain the signals whose gain is amplified efficiently.

The PA apparatus provided in this embodiment has a simple structure, and can improve the yield in the production process and facilitate reducing the production cost.

Embodiment 2 of a PA Apparatus according to an embodiment of the present invention:

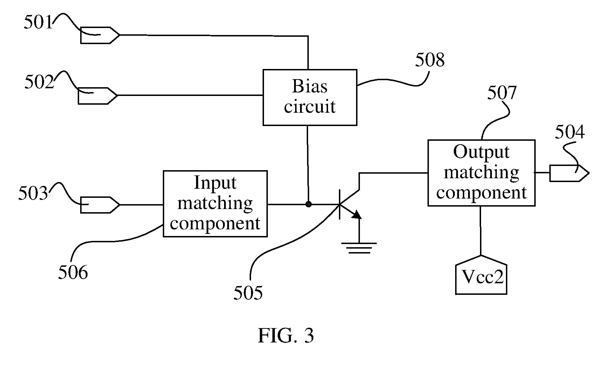

FIG. 3 is a schematic structure diagram of embodiment 2 of a PA apparatus according to an embodiment of the present invention. As shown in FIG. 3, further, the PA apparatus in this embodiment is formed of the following components: a reference voltage unit 501, a voltage control unit 502, a PA tube 505, and a bias circuit 508. The PA tube 505 is configured to amplify gain of the input signals, the bias circuit 508 is configured to provide bias voltage for the PA tube 505, the reference voltage unit 501 is configured to provide voltage for the bias circuit 508, and the voltage control unit 502 is configured to control connection and disconnection of the first stage PA tube 505 through the bias circuit 508.

The PA apparatus in this embodiment further includes an input matching component 506 and an output matching component 507 to prevent or mitigate power loss in the signal transmission process and improve efficiency of the PA apparatus. The input matching component 506 is connected between the signal input end 503 and the PA tube 505, and the output matching component 507 is connected between the signal output end 504 and the PA tube 505.

This embodiment further simplifies the structure of the PA apparatus, and facilitates reducing the production cost and improving the efficiency and yield in the production process.

Embodiment of a Receiving Apparatus of a UE according to an embodiment of the present invention:

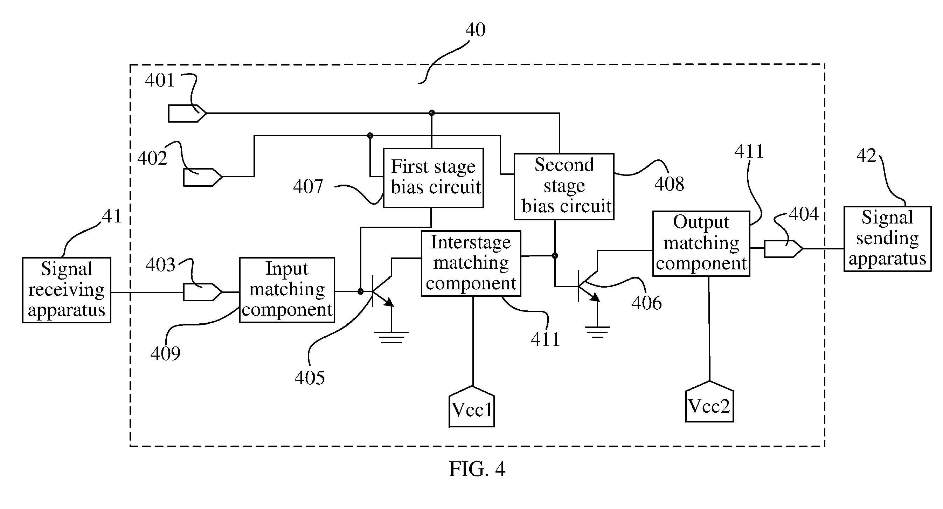

FIG. 4 is a schematic structure diagram of an embodiment of a receiving apparatus of a UE according to an embodiment of the present invention. As shown in FIG. 4, the receiving apparatus of the UE in this embodiment includes a signal receiving apparatus 41, a signal sending apparatus 42, and a PA apparatus 40. The signal receiving apparatus 41 is connected to a signal input end 403 on the PA apparatus 40, and is configured to receive input signals sent from a communication network; the signal sending apparatus 42 is connected to a signal output end 404 on the PA apparatus 40, and is configured to send output signals whose gain is amplified by the PA apparatus 40; and the PA apparatus 40 is the PA apparatus shown in FIG. 2 or FIG. 3, and is configured to amplify gain of all input signals received by the signal receiving apparatus 41, and transfer the amplified input signals to the signal sending apparatus 42 to be sent to the UE.

The PA apparatus 40 on the receiving apparatus of the UE according to the embodiment of the present invention adopts the technical solution of embodiment 1 of the PA apparatus according to the embodiment of the present invention, and includes: a reference voltage unit 401, a voltage control unit 402, a first stage PA tube 405, a second stage PA tube 406, a first stage bias circuit 407, a second stage bias circuit 408, and input matching component 409, an output matching component 410, and an interstage matching component 411. The first stage PA tube 405 is configured to amplify gain of signals; the first stage bias circuit 407 is connected to the first stage PA tube 405, and is configured to provide bias voltage for the first stage PA tube 405; the second stage PA tube 406 is connected to the first stage PA tube 405, and is configured to amplify gain of the signals amplified by the first stage PA tube 405; the second stage bias circuit 408 is connected to the second stage PA tube 406, and is configured to provide bias voltage for the second stage PA tube 406; the reference voltage unit 401 is connected to the first stage bias circuit 407 and the second stage bias circuit 408, and is configured to provide voltage for the first stage bias circuit 407 and the second stage bias circuit 408; the voltage control unit 402 is connected to the first stage bias circuit 407 and the second stage bias circuit 408, and is configured to control connection and disconnection of the first stage PA tube 405 through the first stage bias circuit 407, and control connection and disconnection of the second stage PA tube 406 through the second stage bias circuit 408; the input matching component 409 is connected between the signal input end 403 and the first stage PA tube 405, and is configured to match the signal onto the first stage PA tube 405 to ensure that the signal power is input into the PA apparatus efficiently and the signal is amplified efficiently; the output matching component 410 is connected between the second stage PA tube 406 and the signal output end 404, and is configured to match the signal onto the signal output end 404 to ensure efficient outputting of the power signal amplified by the PA apparatus, reduce power loss, and amplify the signal efficiently; and the interstage matching component 411 is connected between the first stage PA tube 405 and the second stage PA tube 406, and is configured to match the output signals amplified by the first stage PA tube 405 onto the second stage PA tube 406, reduce power loss caused by mismatch between the first stage PA tube 405 and the second stage PA tube 406, and obtain the signals whose gain is amplified efficiently. The reference voltage unit 401 is configured to provide voltage for the first stage bias circuit 407 and the second stage bias circuit 408. The voltage control unit 402 is configured to control connection and disconnection of the first stage PA tube 405 through the first stage bias circuit 407, and control connection and disconnection of the second stage PA tube 406 through the second stage bias circuit 408.

The specific working procedure of the receiving apparatus of the UE in this embodiment is detailed below:

The signal receiving apparatus 41 receives signals from the mobile communication network, and transfers the signals to the signal input end 403 of the PA apparatus 40; the signal input end 403 transmits the signals to the input matching component 409; the input matching component 409 matches the signals output by the signal input end 403 onto the first stage PA tube 405; the first stage PA tube 405 amplifies gain of the signals for the first time, and the signals amplified for the first time are transmitted onto the interstage matching component 411; the interstage matching component 411 matches the amplified signals output by the first stage PA tube 405 onto the second stage PA tube 406; the second stage PA tube 406 amplifies gain of the signals for the second time, and the output matching component 410 matches the signals amplified for the second time onto the signal output end 404 of the PA apparatus 40; the signal output end 404 transmits the signals whose gain is amplified twice to the signal sending apparatus 42; and the signal sending apparatus 42 sends the signals to the UE. In this way, the process of receiving the signals, amplifying gain of the signals, and sending the signals is complete.

When the receiving apparatus of the UE according to the embodiment of the present invention amplifies gain of the signals, the reference voltage on the PA apparatus is fixed, so as to provide stable bias voltage, and maintain a stable gain state while the first stage PA tube and the second stage PA tube amplify the gain of the signals. Because the signal channel is unique when the signals are transmitted in the PA apparatus, conversion of the signals in the signal channel in the PA apparatus is prevented, and the stability of the gain state of the PA apparatus is improved.

With development of communication network technologies, the range of data services is further expanded. As shown in FIG. 1, when a data service is underway, the maximum power output by the whole system of the receiving apparatus of the UE is 24 dBm, and it is highly probable that the power of the output signal is 0 dBm in practical operation. Therefore, the PA apparatus in a terminal needs to ensure high power amplification efficiency of the PA apparatus when the output power of the whole system of the receiving apparatus of the UE is 0 dBm. In a practical network, it is highly probable that the power of signals output by the receiving apparatus of the UE is 10 dBm and 24 dBm. In this way, in a receiving apparatus of a UE in a network such as WCDMA, high power amplification efficiency is required not only at the time of outputting voice whose power is 0 dBm, but also at the time of outputting signals whose power is 10 dBm or 24 dBm.

The inventor of the present invention finds that at the time of designing the receiving apparatus of the UE in a communication network such as WCDMA, it is essential to ensure the power amplification efficiency when the output power of the receiving apparatus of the UE is in three working states of 0 dBm, 10 dBm, and 24 dBm. That is, firstly, it is ensure that the PA has very high power amplification efficiency in the high power state, namely, when the output power of the whole system is 24 dBm; secondly, it is ensured that the PA has high power amplification efficiency in the intermediate power state, namely, when the output power of the whole system is 10 dBm; and thirdly, it is ensured that the PA has high power amplification efficiency in the low power state, namely, when the output power of the whole system is 0 dBm. The PA apparatus disclosed herein ensures high power amplification efficiency when the output power of the receiving apparatus of the UE is 0 dBm, 10 dBm, and 24 dBm respectively.

The receiving apparatus of the UE according to the embodiment of the present invention is applicable not only in a WCDMA mobile communication network, but also in other mobile communication networks such as CDMA and TDMA. The receiving apparatus of the UE according to the embodiment of the present invention is cost-efficient and improves the product yield on one hand, and obtains highly stable output signals on the other hand.

After reading the foregoing embodiments, those skilled in the art are clearly aware that the embodiments of the present invention may be implemented through hardware only, or preferably, through software in addition to a necessary universal hardware platform. Therefore, the technical solution of the present invention or its novelty over the prior art may be embodied in a software product. The software product is stored in a computer-readable storage medium such as computer floppy disk, hard disk and optical disk, and incorporates several instructions for instructing a computer device (for example, personal computer, server, or network device) to execute the method specified in any embodiment of the present invention.

Although the present invention has been described through some exemplary embodiments, the present invention is not limited to such embodiments. It is apparent that those skilled in the art can make modifications and variations to the present invention without departing from the spirit and scope of the present invention. The present invention is intended to cover the modifications and variations provided that they fall in the scope of protection defined by the following claims or their equivalents.

## Claims

1. A Power Amplifier (PA) apparatus, comprising:
a first stage PA tube, configured to amplify gain of all input signals;
a first stage bias circuit connected to the first stage PA tube, configured to provide bias voltage for the first stage PA tube;
a second stage PA tube connected to the first stage PA tube, configured to amplify gain of output signals of the first stage PA tube;
a second stage bias circuit connected to the second stage PA tube, configured to provide bias voltage for the second stage PA tube;
a reference voltage unit connected to the first stage bias circuit and the second stage bias circuit, configured to provide voltage for the first stage bias circuit and the second stage bias circuit; and
a voltage control unit connected to the first stage bias circuit and the second stage bias circuit, configured to control connection and disconnection of the first stage PA tube through the first stage bias circuit, and control connection and disconnection of the second stage PA tube through the second stage bias circuit.

2. The PA apparatus according to claim 1, further comprising:
an input matching component connected to the first stage PA tube, configured to match signals of a signal input end connected to the input matching component onto the first stage PA tube; and
an output matching component connected to the second stage PA tube, configured to match signals of the second stage PA tube onto a signal output end connected to the output matching component.

3. The PA apparatus according to claim 1, further comprising:
an interstage matching component connected between the first stage PA tube and the second stage PA tube, configured to match the output signals of the first stage PA tube onto the second stage PA tube.

4. A receiving apparatus of a User Equipment (UE) adopting the Power Amplifier (PA) apparatus according to any one of claims 1 to 3, comprising:
a PA apparatus, a signal receiving apparatus, and a signal sending apparatus, wherein
the signal receiving apparatus is connected to the PA apparatus, and is configured to receive input signals and transfer the input signals to the PA apparatus;
the signal sending apparatus is connected to the PA apparatus, and is configured to send output signals of the PA apparatus; and
the PA apparatus comprises:
a first stage PA tube, configured to amplify gain of all input signals;
a first stage bias circuit connected to the first stage PA tube, configured to provide bias voltage for the first stage PA tube;
a second stage PA tube connected to the first stage PA tube, configured to amplify gain of output signals of the first stage PA tube;
a second stage bias circuit connected to the second stage PA tube, configured to provide bias voltage for the second stage PA tube;
a reference voltage unit connected to the first stage bias circuit and the second stage bias circuit, configured to provide voltage for the first stage bias circuit and the second stage bias circuit; and
a voltage control unit connected to the first stage bias circuit and the second stage bias circuit, configured to control connection and disconnection of the first stage PA tube through the first stage bias circuit, and control connection and disconnection of the second stage PA tube through the second stage bias circuit.

5. The receiving apparatus of a UE according to claim 4, wherein the PA apparatus further comprises:
an input matching component connected to the first stage PA tube, configured to match signals of a signal input end connected to the input matching component onto the first stage PA tube; and
an output matching component connected to the second stage PA tube, configured to match signals of the second stage PA tube onto a signal output end connected to the output matching component.

6. The receiving apparatus of a UE according to claim 4, further comprising:
an interstage matching component connected between the first stage PA tube and the second stage PA tube, configured to match the output signals of the first stage PA tube onto the second stage PA tube.

7. The receiving apparatus of a UE according to any one of claims 4 to 6, wherein:
the receiving apparatus of the UE comprises: a receiving apparatus of a UE in a Wideband Code Division Multiple Access (WCDMA) system, a receiving apparatus of a UE in a Code Division Multiple Access (CDMA) system, or a receiving apparatus of a UE in a Time Division Multiple Access (TDMA) system.

8. A Power Amplifier (PA) apparatus, comprising a PA tube, a bias circuit, a reference voltage unit, and a voltage control unit, wherein:
the bias circuit is connected to the PA tube, and is configured to provide bias voltage for the PA tube;
the reference voltage unit is connected to the bias circuit, and is configured to provide voltage for the bias circuit; and
the voltage control unit is connected to the bias circuit, and is configured to control connection and disconnection of the PA tube through the bias circuit.

9. The PA apparatus according to claim 8, further comprising:
an input matching component, connected to the PA tube, and configured to match signals of a signal input end connected to the input matching component onto the PA tube; and
an output matching component, connected to the PA tube, and configured to match signals of the PA tube onto a signal output end connected to the output matching component.
